(19) Europäisches Patentamt
European Patent Office
Office européen des brevets

(11) Veröffentlichungsnummer: **0 019 063**
**B1**

(12) # EUROPÄISCHE PATENTSCHRIFT

(45) Veröffentlichungstag der Patentschrift: **21.09.83**

(51) Int. Cl.³: **H 01 L 21/316**, H 01 L 29/62, H 01 L 21/00

(21) Anmeldenummer: **80101625.4**

(22) Anmeldetag: **27.03.80**

(54) **Elektrisch programmierbarer Feldeffekttransistor und Verfahren zu dessen Herstellung.**

(30) Priorität: **21.05.79 US 40805**

(43) Veröffentlichungstag der Anmeldung: **26.11.80 Patentblatt 80/24**

(45) Bekanntmachung des Hinweises auf die Patenterteilung: **21.09.83 Patentblatt 83/38**

(84) Benannte Vertragsstaaten: **DE FR GB**

(56) Entgegenhaltungen:
**DE-A-2 130 908**
**DE-A-2 555 187**
**FR-A-2 077 337**
**JP-A-72 040 145**

**IBM TECHNICAL DISCLOSURE BULLETIN, Band 21, Nr. 8, Januar 1979, New York, US, D.L. BERGERON et al.: «Aluminium gate self-aligned FET», Seiten 3273–3274**

**IBM TECHNICAL DISCLOSURE BULLETIN, Band 14, Nr. 5, Oktober 1971, New York, US, G.E. MITCHELL: «Fabricating FETs (FIELD-EFFECT TRANSISTORS)», Seiten 1408–1410**

**PATENTS ABSTRACTS OF JAPAN, Band 3, Nr. 44, 14. April 1979, Seite 97 E104, Tokyo, JP**

(73) Patentinhaber: **International Business Machines Corporation, Old Orchard Road, Armonk, N.Y. 10504 (US)**

(72) Erfinder: **Bergeron, David L., 21 Dufresne Drive, Winooski, Vermont 05404 (US)**
Erfinder: **Smith, Paul H., 27 Aurielle Drive, Colchester, Vermont 05446 (US)**

(74) Vertreter: **Schröder, Otto H., Dr.-Ing., c/o International Business Machines Corporation Zurich Patent Operations Säumerstrasse 4, CH-8803 Rüschlikon/ZH (CH)**

**EP 0 019 063 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Elektrisch programmierbarer Feldeffekttransistor und Verfahren zu dessen Herstellung

Die Erfindung betrifft einen bipolaren, elektrisch programmierbaren Feldeffekttransistor der im Oberbegriff des Anspruchs 1 näher bezeichneten Art und ein Verfahren zu dessen Herstellung.

Aus der FR-A 2 077 337 ist ein Halbleiterbauelement mit verringerter Grenzflächenladung bekannt, bei welchem zwischen einer auf der Oberfläche des Halbleitersubstrats liegenden $SiO_2$-Schicht und einer darüberliegenden Schicht aus $Si_3N_4$ eine weitere Schicht aus Aluminium vorgesehen ist, die vor Aufbringen der $Si_3N_4$-Schicht durch Anlassen bei 550 °C für 10 Minuten an die $SiO_2$-Schicht anlegiert wird. Dies ist jedoch kein Festwertspeicherelement. Die Grundlage aller elektrisch programmierbaren, nichtflüchtigen Festwertspeicher (EPROM) besteht in der Möglichkeit, eine Ladung an einem Knotenpunkt hoher Impedanz innerhalb einer Halbleitervorrichtung zu speichern. Die Anwesenheit einer gespeicherten Ladung muss durch eine Einwirkung auf Kennwerte eines Feldeffekttransistors feststellbar sein. Die Forderung nach einer hohen Impedanz des Speicherknotenpunktes ergibt sich aus der nichtflüchtigen Speicherung.

Typische Speicherknotenpunkte sind: 1. spannungsfreie, elektrisch leitende Gateelektroden (wie z.B. aus Polysilicium) oder 2. nichtleitende, elektrische Fangstellen innerhalb des Dielektrikums der Halbleitervorrichtung (wie z.B. an den Trennflächen zwischen zwei Isolierschichten, wobei eine Isolierschicht gewöhnlich aus $SiO_2$ und die andere aus einem anderen dielektrischen Material, wie z.B. $Si_3N_4$ oder $Al_2O_3$ besteht).

In einem typischen EPROM wird der Ladungsspeicher-Knotenpunkt dazu benutzt, die gesamte MOS-Struktur vorzuspannen, wodurch sich die Schwellwertspannung der Vorrichtung ändert. Es kann gezeigt werden, dass die Empfindlichkeit der Schwellwertspannung der Vorrichtung bei einer Änderung der Ladung auf dem Speicherknotenpunkt ($Q_T$) proportional dem Abstand zwischen der metallischen Gateelektrode und den Fangstellen ist (für eine konstante Gesamtdicke der Isolierschichten), oder

$$\frac{dV}{dQ_t} = \frac{-1}{\varepsilon_0 \varepsilon_1} X_1.$$

Fig. 1 zeigt eine Querschnittsansicht eines an einem geschichteten Dielektrikum angeordneten Ladungsspeicher-Knotenpunktes gemäss dem Stande der Technik, wobei über einer ersten Schicht 4 eines Dielektrikums mit der Dicke X1 auf der Oberfläche eines Siliciumsubstrats 2 eine zweite Schicht 6 aus einem Dielektrikum mit einer Dicke X2 angeordnet ist. Die erste dielektrische Schicht 4 kann dabei beispielsweise aus Siliciumdioxid bestehen, während die zweite dielektrische Schicht 6 aus Siliciumnitrid bestehen kann. Auf der Oberseite der dielektrischen Schicht 6 liegt eine elektrisch leitende Schicht 10, die als die Programmier-Gateelektrode für diese Schichtenfolge dient. Es wurde festgestellt, dass sich die elektrischen Ladungen an der Trennfläche 8 zwischen der unteren dielektrischen Schicht 4 und der oberen dielektrischen Schicht 6 konzentrieren. Die Ladungen können dabei durch eine Reihe an sich bekannter Verfahren injiziert werden, nämlich durch Lawineninjektion oder Tunnelinjektion, so dass dann, wenn die Programmier-Gateelektrode 10 in bezug auf das Substrat 2 richtig vorgespannt ist, Ladungen an der Trennfläche 8 hinzugefügt oder abgezogen werden können. Wenn den zusammengesetzten dielektrischen Schichten in dem Siliciumsubstrat 2 eine einzige Diffusionszone gegenüberliegt, kann selektiv eine Kapazität gebildet werden. Werden in dem Siliciumsubstrat 2 erste und zweite diffundierte Zonen gebildet, die durch die äusseren Kanten der zusammengesetzten dielektrischen Schichten 14 begrenzt sind (Fig. 1B), dann entsteht auf diese Weise ein Feldeffekttransistor mit selektiver Elektronenleitfähigkeit. Je näher der Ladungsknotenpunkt 8 an der Siliciumoberfläche des Substrats 2 liegt, um so weniger Ladung muss für eine Änderung des Schaltzustandes des Transistors dem Ladungsspeicher-Knotenpunkt zugeführt oder von dort abgeführt werden. Für Feldeffekttransistoren, deren Speicherknotenpunkt sehr nahe an der Siliciumoberfläche liegt, wird möglicherweise für eine Programmierung des Transistors weniger Zeit erforderlich sein, und für diese Programmierung könnten möglicherweise geringere Spannungen verwendet werden.

In einer Untersuchung über die Haftfähigkeit von Aluminium auf Siliciumdioxid wird in einem kürlich veröffentlichten Bericht von J.R. Black, «The Reaction of Al with Vitreous Silica», Papier 8.2 des International Reliability Physics Symposiums vom 14.04.1977 eine Festkörperreaktion zwischen einer Schicht 16 aus Aluminium und thermischem Siliciumdioxid 18 beschrieben.

$$4Al + 3SiO_2 \rightarrow 2Al_2O_3 + 3Si$$

Diese Reaktion ist thermodynamisch besonders vorteilhaft bei typischen Sintertemperaturen von 400 bis 500 °C. Die Reaktionsgeschwindigkeit wird durch Festkörperdiffusion gesteuert und ergibt eine Zone 20 innerhalb der ursprünglichen Oxidschicht 18, die sich von der Metalloxid-Trennfläche 22 aus erstreckt, und die von $SiO_2$ in eine Matrix von $SiO_2$, $Al_2O_3$ und Si umgewandelt wird, wie dies Fig. 2 zeigt. Da die Reaktion durch Diffusion begrenzt ist, ist eine ausgezeichnete Steuerung der Reaktionstiefe möglich. Wie durch J.R. Black berichtet wird, liegen typische Eindringgeschwindigkeiten zwischen 0,1 nm/min bei 400 °C bis 6 nm/min bei 540 °C.

Die der Erfindung zugrundeliegende Aufgabe besteht somit darin, für einen programmierbaren Festwertspeicher mit selbstausrichtender Source- und Drain-Zone in bezug auf eine spannungsfreie Gateelektrode, eine genauere Plazierung eines Ladungsträger-Speicherknotenpunktes in einer

dielektrischen Schicht und insbesondere eine genauere Plazierung von Ladungsspeicher-Fangstellen innerhalb einer Siliciumdioxidschicht anzugeben.

Die der Erfindung zugrundeliegende Aufgabe wird für eine bipolare, elektrisch programmierbare Festwertspeicher-Anordnung durch die hier offenbarte Anordnung und das hier offenbarte Fertigungsverfahren gelöst. Eine bipolare, elektrisch programmierbare Festwertspeicher-Anordnung mit in der Präambel des Patentanspruchs 1 angegebenen elektrisch programmierbaren Feldeffekttransistoren und das zugehörige Herstellungsverfahren bauen auf der Bildung einer aus Aluminium bestehenden Gateelektrodenstruktur auf der Oberfläche einer dünnen Oxidschicht in einem halbfertigen Feldeffekttransistor auf, wobei die aus Aluminium bestehende Gateelektrodenstruktur als Sperrmaske bei der Ionenimplantation für die Bildung von selbstausgerichteten Source- und Drain-Zonen und ausserdem als Quelle für das Aluminium für die Festkörperrekation zwischen der Siliciumdioxidschicht und dem Aluminium dient, wodurch eine aus Aluminiumoxid/Siliciumdioxid bestehende, zusammengesetzte Ladungsspeicherzonge gebildet wird. Das neue Verfahren ist dabei vollständig mit bestehenden bipolaren Verarbeitungstechniken verträglich, so dass auf dem gleichen Halbleiterplättchen, zusammen mit der hier offenbarten, bipolaren Festwert-Speicheranordnung die zusätzlich erforderlichen, mit hoher Geschwindigkeit arbeitenden, bipolaren Schaltungen vorgesehen werden können. Der programmierbare, bipolare Transistor hat dabei den einmaligen Vorteil, dass für die Programmierung eine Spannung verwendet wird, die praktisch völlig an die für die übrigen Schaltungen auf dem Halbleiterplättchen benötigten Signalspannungen dadurch angepasst werden kann, dass man die Festkörperreaktion bei der Bildung des Aluminiumoxids entsprechend steuert. Geringere Programmierspannungen ermöglichen Halbleiterstrukturen mit geringeren Abständen und damit auch eine Reduzierung der Anzahl der für das fertige Halbleiterplättchen erforderlichen Spannungsquellen. Weitere Ausführungsformen des Verfahrens und der Vorrichtung sind ebenfalls offenbart.

Weitere Ausführungsformen der Erfindung können den Unteransprüchen im einzelnen entnommen werden.

Die Erfindung wird nunmehr anhand von Ausführungsbeispielen in Verbindung mit den beigefügten Zeichnungen im einzelnen erläutert.

In den Zeichnungen zeigt:

Fig. 1a eine Querschnittsansicht eines Speicherknotenpunktes gemäss dem Stande der Technik mit einfacher Diffusion und doppeltem Dielektrikum,

Fig. 1b eine Querschnittsansicht des Speicherknotenpunktes gemäss Fig. 1 mit doppelter Diffusion,

Fig. 2a eine Querschnittsansicht der Festkörperreaktion zwischen Aluminium und Siliciumdioxid,

Fig. 2b das durch das in Fig. 2a eingeleitete Verfahren sich einstellende Ergebnis einer festen Lösung,

Fig. 3a bis 3f eine Folge von Querschnittsansichten einer ersten Ausführungsform des erfindungsgemässen Verfahrens,

Fig. 4a bis 4d eine Folge von Schnittansichten zur Darstellung einer zweiten Ausführungsform des erfindungsgemässen Verfahrens und

Fig. 5a bis 5d eine Folge von Schnittansichten zur Darstellung einer dritten Ausführungsform des erfindungsgemässen Verfahrens.

Beschreibung der bevorzugten Ausführungsformen der Erfindung

Die pipolare, elektrisch programmierbare oder veränderbare Festkörper-Speicheranordnung und das hier offenbarte Verfahren zur Herstellung dieser Speicheranordnung geht auf die Erkenntnis des Erfinders zurück, dass die durch Black offenbarte Festkörperreaktion bei der Bildung von mit zwei Dielektrika ausgestatteten Ladungsspeicherpunkten und zugeordneten Schaltungen benutzt werden kann. Diese neuartigen Halbleitervorrichtungen haben den einzigartigen Vorteil, dass sie eine Programmierspannung haben, die im wesentlichen so eingestellt werden kann, dass sie an die Signalspannungen für den Rest des Halbleiterplättchens dadurch angepasst werden kann, dass die Festkörperreaktion bei der Bildung des Aluminiumoxids entsprechend gesteuert wird. Mit niedrigen Programmierspannungen lassen sich Halbleiterstrukturen mit engeren Abständen herstellen, und die Anzahl der für das Halbleiterplättchen erforderlichen Spannungsquellen kann ebenfalls verringert werden.

Die Erfinder haben festgestellt, dass ausser Aluminium auch andere Metalle sich thermodynamisch für die Festkörperreaktion zur Bildung der Ladungsspeicher-Knotenpunkte eignen. Dafür geeignete Metalle, die anstelle von Aluminium verwendet werden können, mit dem Black Versuche durchgeführt hat, müssen thermodynamisch in der Lage sein, $SiO_2$ in einer Reaktion unter Bildung eines Metalloxids und Silicium als Reaktionsprodukte unter gemässigten Sintertemperaturen zu reduzieren, wobei durch diese Reaktion ein dielektrisches Material gebildet wird, dessen Trennfläche mit der das dielektrische Material aufnehmenden Siliciumdioxidschicht 18 als geeigneter Speicherknotenpunkt für eine elektrische Ladung zu dienen vermag. Geeignete Materialien sind beispielsweise Beryllium und Titan, also hochfeuerfeste Metalle mit relativ hohen Schmelztemperaturen. Ein weiteres Metall, das anstelle von Aluminium eingesetzt werden kann, ist Magnesium, das in bezug auf den Schmelzpunkt von Aluminium einen eher vergleichbaren Schmelzpunkt aufweist.

Zur Erläuterung der verschiedenen Verfahren, die durch die Erfinder zur Herstellung der erfindungsgemässen Knotenpunkte und Halbleitervorrichtungen entwickelt wurden, sollen zunächst die Fig. 3a bis 3f dienen.

Fig. 3a zeigt eine erste Stufe in dem ersten Verfahren, bei dem auf einem Siliciumsubstrat 24, das beispielsweise aus P-leitendem Silicium mit 1 bis 10 Ohm-cm bestehen kann, eine Siliciumdioxidschicht 26 mit einer Dicke von angenähert 300 nm gebildet ist. Dies kann beispielsweise eine thermisch aufgewachsene Siliciumdioxidschicht sein. In der Siliciumdioxidschicht 26 werden erste und zweite Kontaktöffnungen 28 und 30, beispielsweise durch übliche photolithographische Verfahren gebildet.

Fig. 3b zeigt die zweite Stufe des ersten Verfahrens, bei welcher eine Aluminiumschicht 32 mit einer Dicke von etwa 700 nm niedergeschlagen und durch photolithographische Verfahren auf einen Teil der Oberfläche der Siliciumdioxidschicht 26 begrenzt ist. Als nächstes wird gemäss Fig. 3c eine Photolackschicht 34 aufgebracht, die als Ionenimplantationsmaske dient und den Bereich der Halbleitervorrichtung freigibt. Anschliessend werden N-leitende Ionen 36 mit hoher Energie und hoher Dosierung implantiert, wobei normalerweise Phosphor-Ionen verwendet werden. Die Strahlenenergie liegt dabei in der Grössenordnung von 300 Kev, und die Dosierung beträgt $5 \times 10^{13}$ bis $1 \times 10^{15}$ Atome/cm². Dadurch erhält man in dem P-leitenden Substrat 24 eine ionenimplantierte N-leitende Source-Zone 38 und eine ionenimplantierte N-leitende Drain-Zone 40. Die Dicke der Aluminiumschicht 32 dient dazu, die Ionenimplantation der Ionen 36 in der Kanalzone 42 der Halbleitervorrichtung selektiv zu verhindern.

In Fig. 3d ist die Photolackschicht 34 entfernt. Zu diesem Zeitpunkt wird die Halbleitervorrichtung in einen Ofen eingebracht, so dass das Sinterverfahren durchgeführt werden kann. Wie bereits beschrieben, erfolgt bei dem Sinterverfahren eine Festkörperreaktion zwischen der Aluminiumschicht 32 und der Siliciumdioxidschicht 26. Für diese Reaktion sind Sintertemperaturen von 400 bis 500 °C thermodynamisch gesehen günstig. Die Reaktionsgeschwindigkeit wird durch Festkörperdiffusion gesteuert und ergibt eine Zone 44, die aus einer Matrix besteht, die die Reaktionsprodukte $Al_2O_3$ und Silicium in der Siliciumdioxidschicht enthält. Diese Zone 44 erstreckt sich von der ursprünglichen Trennfläche zwischen Siliciumdioxidschicht 26 und Aluminiumschicht 32 bis zu einer Tiefe $Y_3$ in die Siliciumdioxidschicht 26 hinein. Da die Reaktion durch die Diffusion begrenzt wird, ist eine ausgezeichnete Steuerung der Tiefe $Y_3$ möglich. Typische Eindringgeschwindigkeiten der Zone 44 liegen zwischen 0,2 nm/min bei 400 °C bis 5 nm/min bei 540 °C. In einem besonderen Beispiel liegt dann, wenn der Ofen bei einer Temperatur von 525 °C betrieben wird, die Eindringgeschwindigkeit bei etwa 2 nm/min, so dass dann, wenn eine Eindringtiefe $Y_3$ von 200 nm gewünscht ist, der Sintervorgang für eine Dauer von 100 Minuten durchgeführt werden muss. Die sich daraus ergebenden Abmessungen in senkrechter Richtung für die Ladungsspeichervorrichtung sind folgende: Die Siliciumdioxidschicht $Y_1$ ist 300 nm dick, die Eindringtiefe der Zone 44, $Y_3$ beträgt 200 nm, und damit beträgt der Abstand zwischen einem Ladungsspeicher-Knotenpunkt an der Trennfläche 48 zwischen der Zone 44 und der Siliciumdioxidschicht 26 $Y_2 = 100$ nm.

Fig. 3e zeigt die nächste Stufe des Verfahrens, nach dem die Halbleitervorrichtung aus dem Ofen entnommen und die überschüssige Aluminiumschicht 32 in einem Ätzbad abgezogen worden ist. Die Halbleitervorrichtung wird dann bei einer Temperatur von etwa 900 bis 1100 °C für eine Dauer von angenähert 30 Minuten angelassen, um dadurch die in den Zwischengitterplätzen durch Ionenimplantation liegenden Phosphoratome in dem Siliciumsubstrat 24 nach Substitutions-Gitterplätzen umzuwandeln, um dadurch die Dotierungsformen zu aktivieren.

Fig. 3f zeigt die letzte Stufe des Verfahrens zur Darstellung der Struktur der Halbleitervorrichtung, bei der eine zweite Metallisierungsschicht 50 über der Zone 44 niedergeschlagen wird und damit die Programmier-Gateelektrode für den sich ergebenden programmierbaren Feldeffektransistor ergibt. Gleichzeitig mit dem Niederschlagen der Programmier-Gateelektrode 50 werden Metallkontakte 52 und 54 über den ionenimplantierten Zonen 38 und 40 zur Bildung von Source- und Drain-Kontakten niedergeschlagen. Die Metallschichten für die Gateelektrode 50 und die Anschlusskontakte 52 und 54 können beispielsweise aus Aluminium bestehen.

Die fertige, in Fig. 3f gezeigte Halbleitervorrichtung kann beispielsweise in bekannter Weise durch Lawineninjektion oder Tunnelinjektion programmiert werden. Die relativen Ladungsmengen, die an der Trennfläche 48 zwischen dielektrischer Zone 44 und Siliciumdioxidschicht 26 gespeichert werden, bestimmen die relative Elektronenleitfähigkeit des Kanalbereichs 42 des programmierbaren Feldeffekttransistors.

Die sich ergebende bipolare, elektrisch programmierbare Festkörper-Speichervorrichtung und das Herstellungsverfahren sind mit bipolaren Herstellungsverfahren mit Aluminiummetallisierung verträglich, bei dem das Substrat N-leitend und die implantierten Source- und Drain-Zonen P-leitend sind, wodurch die entsprechenden bipolaren Schaltungen in den Decodiererschaltungen gleichzeitig auf dem gleichen Halbleiterplättchen mit der aus Feldeffekttransistoren bestehenden, elektrisch programmierbaren Speicheranordnung hergestellt werden können. Bei diesem Verfahren ist es nicht erforderlich, mit polykristallinem Silicium zu arbeiten, so dass dadurch die Anzahl der Verfahrensschritte bei der Herstellung verringert wird. Die elektrisch programmierbare Halbleitervorrichtung kann eine genau angepasste Programmierspannung aufweisen, die dadurch erzielbar ist, dass man nach dem in Zusammenhang mit Fig. 3d beschriebenen Sintervorgang die Dikke $Y_1$ der Siliciumdioxidschicht 26 entsprechend einstellt. Dadurch kann beim Entwurf einer solchen integrierten Schaltung sichergestellt werden, dass die elektrisch programmierbare Halbleitervorrichtung mit angenähert den gleichen Spannungen arbeitet, wie sie für den Rest der

integrierten Schaltungen auf dem Halbleiterplättchen verwendet werden. Dadurch wird nicht nur die Anzahl der erforderlichen Versorgungsspannungen verringert, sondern man erhält auch eine gedrängtere Anordnung, da hier Vorrichtungen mit kleineren Durchmesserspannungen benutzt werden können, was mit der hier geforderten, geringeren Programmierspannung verträglich ist. Die elektrisch programmierbare Festwertspeichervorrichtung hat einen in bezug auf den Kanalbereich 42 zwischen Source- und Drain-Zonen 38 bzw. 40 selbstausgerichteten Speicherknotenpunkt, nämlich die Trennfläche 48. Dadurch können bei der Anordnung der einzelnen Halbleiterbauelemente auf dem Halbleiterplättchen engere photolithographische Toleranzen eingesetzt werden.

Eine andere Vorrichtung kann durch zwei weitere Verfahren hergestellt werden, wie sie anhand der Fig. 4a bis 4d und 5a bis 5d gezeigt sind. Bei dieser abgewandelten Ausführungsform erhält man eine Selbstausrichtung für den Speicherknotenpunkt und die Auswahl- oder Programmier-Gateelektrode in bezug auf Source- und Drain-Zonen.

Fig. 4a bis 4d zeigen das zweite Verfahren, bei dem die Metallschicht 32 aus einem hochschmelzenden Metall besteht, das auch das Anlassverfahren für die Ionenimplantation aushält und ebenso das Siliciumdioxid reduziert. Fig. 4a entspricht Fig. 3a., Fig. 4b entspricht Fig. 3b, wo anstelle von Aluminium, entsprechend Fig. 3b, Titan oder Beryllium eingesetzt wird. Die Metallschicht 32 dient dabei als Implantationsmaske für den nachfolgenden Ionenimplantationsschritt gemäss Fig. 3 und ausserdem als Programmier-Gateelektrode für die Halbleitervorrichtung. Die Sinterung wird in Fig. 4b in ähnlicher Weise durchgeführt, wie für Fig. 3d. Die Festkörperreaktion zwischen dem hochschmelzenden Metall 32 und der Siliciumdioxidschicht kann bei einer geeigneten Sintertemperatur, beispielsweise zwischen 400 und angenähert 500 °C durchgeführt werden. DieReaktionsgeschwindigkeit wird durch Festkörperdiffusion gesteuert und ergibt eine Zone 44 in Fig. 4b innerhalb der ursprünglichen Siliciumdioxidschicht 26, welche sich aus den Reaktionsprodukten, nämlich dem Metalloxid und reduziertem Silicium sowie dem restlichen Siliciumdioxid zusammensetzt. Die sich dabei ergebende Trennfläche 48 zwischen Metalloxid und Siliciumdioxid dringt um einen Abstand $Y_3$ ein, der der Dauer des Sinterverfahrens und der dabei verwendeten Temperatur proportional ist.

Fig. 4c zeigt den nächsten Schritt, nämlich den Niederschlag einer Photolackschicht 34, durch die die ionenimplantierten Zonen 38 und 40 definiert werden, die schliesslich als Source- und Drain-Zonen eines programmierbaren Feldeffekttransistors dienen. Die Dicke der hochschmelzenden Metallschicht 32 wird dabei so gewählt, dass effektiv eine Implantation von Ionen 36 im Kanalbereich 42 zwischen Source- und Drain-Zone 38 bzw. 40 während deren Bildung verhindert wird. Wie zuvor können für die Ionenimplantation Phosphorionen verwendet werden, und die Ionenimplantation kann unter den gleichen Bedingungen durchgeführt werden, wie im Zusammenhang mit Fig. 3c beschrieben.

Fig. 4d zeigt dann die fertige Struktur der durch dieses Verfahren erzeugten Halbleitervorrichtung mit Anschlusskontaktschichten 52 und 54 für Source- bzw. Drain-Zone 38 bzw. 40.

Zusätzlich zu den bereits erwähnten Vorteilen der Halbleitervorrichtung, die gemäss dem Verfahren nach Fig. 3a bis 3f erzeugt wurden, hat die in Fig. 4d gezeigte Vorrichtung den Vorteil, dass die Ladungsspeicher-Trennfläche 48 von selbst, in bezug auf die Programmier-Gateelektrode 32 und in bezug auf den Kanalbereich 42, zwischen Source- und Drain-Zone 38 bzw. 40 ausgerichtet ist. Dadurch wird die dichte Anordnung und das Betriebsverhalten der in Fig. 3f gezeigten Vorrichtung noch weiter verbessert.

Fig. 5a bis 5c zeigt eine weitere Abwandlung des erfindungsgemässen Verfahrens, bei dem die Metallschicht 32 nach Bildung von Source- und Drain-Zonen 56 bzw. 58 niedergeschlagen wird. Wie aus Fig. 5a zu erkennen, werden N-leitende Source- und Drain-Zonen 56 bzw. 58 in einem P-leitenden Substrat 24 gebildet, so dass dazwischen ein Kanalbereich 60 gebildet wird. Diese Zonen werden vor dem Niederschlag der Metallschicht 32 gemäss Fig. 5b hergestellt. Die Source- und Drain-Zonen 56 bzw. 58 können durch jedes beliebige bekannte Verfahren, wie beispielsweise thermische Diffusion oder Ionenimplantation, hergestellt werden.

Fig. 5c zeigt das Sintern der Metallschicht 32 zur Durchführung der oben beschriebenen Festkörperreaktion zur Erzeugung der Zone 44 mit einer Ladungsspeicher-Trennfläche 48 in bezug auf die Siliciumdioxidschicht 26. Fig. 5d zeigt den letzten Verfahrensschritt und den Aufbau dieser Vorrichtung, wobei metallische Kontakte 52 und 54 über Source- und Drain-Zonen 56 bzw. 58 niedergeschlagen sind. In dieser Ausführungsform kann die Programmier-Gateelektrode 32 aus einem nicht hochschmelzenden Metall, wie z.B. Aluminium oder Magnesium, bestehen, wie dies bereits beschrieben wurde oder aber aus einem hochschmelzenden Metall, wie z.B. Beryllium oder Titan, da die Metallschicht 32 keinem nachfolgenden Hochtemperatur-Verfahrensschritt ausgesetzt ist. Diese Ausführungsform hat zwar ebenfalls die Vorteile der Selbstausrichtung zwischen der Trennfläche 48 und der programmierbaren Gateelektrode 32, weist aber keine Selbstausrichtung zwischen Gateelektrode 32 oder Trennfläche 48 für die Ladungsspeicherung in bezug auf den Kanalbereich zwischen Source-Zone 56 und Drain-Zone 58 auf. Diese Ausführungsform benötigt jedoch keine Ionenimplantation bei der Bildung der verbesserten Ladungsspeichereigenschaften für die Halbleitervorrichtung.

Die bipolare, elektrisch änderbare oder programmierbare Festwert-Speichervorrichtung und das Herstellungsverfahren dafür sind mit der Aluminiummetallisierung und der Herstellung von bipolaren Halbleitervorrichtungen verträglich, so

dass eine gleichzeitige Herstellung von bipolaren Schaltungen der Decodiererschaltungen mit aus Feldeffekttransistoren bestehenden, programmierbaren Speichervorrichtungen auf dem gleichen Halbleiterplättchen möglich sind. Das Verfahren läuft ohne Verarbeitung von Polysilicium ab, wodurch sich die Anzahl der Verfahrensschritte verringert. Die elektrisch programmierbare Halbleitervorrichtung kann dabei eine genau angepasste Programmierspannung aufweisen, die dadurch erzielt wird, dass man die nach dem Sinterverfahren verbleibende Dicke der Siliciumdioxidschicht entsprechend verändert. Dadurch kann beim Entwurf eine elektrisch programmierbare Halbleitervorrichtung geschaffen werden, die etwa bei angenähert den gleichen Spannungen arbeitet, wie sie für die übrigen, auf einem mit integrierten Schaltungen versehenen Halbleiterplättchen verwendet werden. Dadurch wird nicht nur die Anzahl der erforderlichen Versorgungsspannungen verringert, sondern man erhält auch eine dichtere Anordnung, da die Möglichkeit eines dielektrischen Durchschlags zwischen benachbarten leitenden Strukturen bei der hier benötigten geringeren Programmierspannung ebenfalls verringert ist. Die elektrisch programmierbare Festkörper-Speichervorrichtung hat einen selbstausgerichteten Speicherknotenpunkt in bezug auf Source- und Drain-Zone, so dass engere photolithographische Toleranzen bei der Anordnung der Halbleiterbauelemente auf dem Halbleiterplättchen verwendet werden können.

**Patentansprüche**

1. Elektrisch programmierbarer Feldeffekttransistor mit einer auf der Oberfläche eines Halbleitersubstrats (24) eines ersten Leitungstyps angebrachten Siliciumdioxidschicht und einer darüberliegenden aus Aluminium bestehenden Metallschicht sowie mit zwei ionenimplantierten Zonen erhöhter Leitfähigkeit des zum Leitungstyp des Substrats entgegengesetzten Leitungstyps, deren innenliegende Kanten mit den aussenliegenden Kanten der metallischen Schicht selbstausrichtend ausgerichtet sind und damit Source- und Drain-Zonen des Feldeffekttranistors bilden sowie mit einer weiteren, innerhalb der Siliciumdioxidschicht liegenden Schicht, deren aussenliegende Kanten mit den innenliegenden Kanten der beiden ionenimplantierten Zonen ausgerichtet sind, dadurch gekennzeichnet, dass die weitere Schicht unmittelbar anschliessend unter der metallischen Schicht aus einer Matrix aus den Reaktionsprodukten Aluminiumoxid und Silicium aus der bei Temperaturen von 400 bis 500 °C ablaufenden Festkörperreaktion gemäss der Reaktionsgleichung

$$4Al + SiO_2 \rightarrow 2Al_2O_3 + 3Si$$

besteht und einen Ladungsspeicherbereich für einen elektrisch programmierbaren Feldeffekttransistor bildet.

2. Feldeffekttransistor nach Anspruch 1, dadurch gekennzeichnet, dass die innenliegenden Kanten der ionenimplantierten Zonen (38, 40) die Kanten der metallischen Schicht (32) überlappen.

3. Feldeffekttransistoren nach Anspruch 2, dadurch gekennzeichnet, dass die aussenliegenden Kanten der Schicht (44) die innenliegenden Kanten der ionenimplantierten Zonen (38, 40) überlappen.

4. Verfahren zum Herstellen eines elektrisch programmierbaren Feldeffekttransistors als Speicherknotenpunkt in einem Halbleitersubstrat (2; 24) eines ersten Leitungstyps, welches mit einer Isolierschicht (18; 26) aus Siliciumdioxid überzogen ist, gemäss Anspruch 1, durch Niederschlagen einer Aluminiumschicht (16; 32) auf der Oberfläche der Siliciumdioxidschicht mit einer Dicke, die in Verbindung mit der Dicke der $SiO_2$-Schicht eine ausreichend dicke Maske für eine nachfolgende Ionenimplantation bildet, durch Ionenimplantation eines die Leitfähigkeit erhöhenden Störelements (36) des zweiten Leitungstyps durch die sich an die metallische Schicht anschliessende Siliciumdioxidschicht hindurch, zur Bildung von mit Ionen implantierten Zonen (38, 40), mit einem über der Kante der metallischen Schicht (32) ausgerichteten Anschlussanschnitt, gekennzeichnet durch Sintern der metallischen Schicht zum Einleiten einer Festkörperreaktion zwischen der Aluminiumschicht und der Siliciumdioxidschicht gemäss der Reaktionsformel:

$$4Al + 3SiO_2 \rightarrow 2Al_2O_3 + 3Si$$

unter Bildung einer innerhalb der mit dem Anschlussabschnitt der ionenimplantierten Zonen und der Aluminiumschicht ausgerichteten Siliciumdioxidschicht (44) liegenden Matrix aus Aluminiumoxid und Silicium, zur Bildung eines elektrisch programmierbaren Speicherknotenpunktes.

**Claims**

1. Electrically programmable field effect transistor with a silicon dioxide layer provided on the surface of a semiconductor substrate (24) of a first conductivity type, and a superimposed metal layer consisting of aluminium, and with two ion-implanted regions of enhanced conductivity of the opposite conductivity type of that of the substrate, the inner edges of these regions being arranged in self-alignment with the outer edges of the metallic layer, and thus forming source and drain regions of the field effect transistor, and with another layer provided inside the silicon dioxide layer, the outer edges of said additional layer being in alignment with the inner edges of the two ion-implanted regions, characterized in that the additional layer immediately beneath the metallic layer consists of a matrix of the reaction products aluminum oxide and silicon of the solid reaction executed at temperatures of 400 to 500 °C, in accordance with the reaction equation

$$4Al + SiO_2 \rightarrow 2Al_2O_3 + 3Si$$

and which forms a charge storage region for an electrically programmable field effect transistor.

2. Field effect transistor as claimed in claim 1, characterized in that the inner edges of the ion-implanted regions (38, 40) overlap the edges of the metallic layer (32).

3. Field effect transistor as claimed in claim 2, characterized in that the outer edges of the layer (44) overlap the inner edges of the ion-implanted regions (38, 40).

4. Method of making an electrically programmable field effect transistor as a storage node in a semiconductor substrate (2; 24) of a first conductivity type coated with an insulating layer (18, 26) of silicon dioxide, according to claim 1, by depositing an aluminum layer (16; 32) on the surface of the silicon dioxide layer with a thickness which in combination with the thickness of the $SiO_2$ layer forms a sufficiently thick mask for a subsequent ion-implantation, by ion-implanting a conductivity-enhancing impurity element (36) of the second conductivity type through the silicon dioxide layer adjacent to the metallic layer, to form ion-implanted regions (38, 40), with a subsequent portion aligned over the edge of the metallic layer (32), characterized by sintering the metallic layer to initiate a solid state reaction between the aluminum layer and the silicon dioxide layer in accordance with the reaction formula

$$4Al + 3SiO_2 \rightarrow 2Al_2O_3 + 3Si$$

forming a matrix of aluminum oxide and silicon within the silicon dioxide layer (44) in alignment with the subsequent portion of the ion-implanted regions and the aluminum layer, to form an electrically programmable storage node.

**Revendications**

1. Transistor à effet de champ programmable électriquement comportant une couche de silicium déposée sur la surface d'un substrat semiconducteur (24) d'un premier type de conductivité sur laquelle est superposée une couche métallique en aluminium et comportant également deux zones dopées p ou n dont la conductibilité du type de conduction opposée au type de conduction dudit substrat est plus élevée, les bords internes desdites régions étant alignés automatiquement sur les bords externes de la couche métallique constituant ainsi les zones source et drain dudit transistor à effet de champ, comportant également une autre couche incluse dans la couche de silice et dont les bords externes sont alignés sur les bords internes des deux dites zones dopées p ou n, caractérisé en ce que cette dernière couche, située immédiatement sous ladite couche métallique, constitue une matrice composée des produits alumine et silicium obtenus par réaction à l'état solide à des températures comprises entre 400 et 500 °C, selon l'équation

$$4Al + SiO_2 \rightarrow 2Al_2O_3 + 3Si$$

et en ce que cette dernière couche métallique constitue une région d'emmagasinage des charges d'un transistor à effet de champ programmable électriquement.

2. Transistor à effet de champ selon la revendication 1, caractérisé en ce que les bords internes des zones dopées p ou n (38, 40) recouvrent les bords de ladite couche métallique (32).

3. Transistors à effet de champ selon la revendication 2, caractérisés en ce que les bords externes de ladite couche (44) recouvrent les bords internes des zones dopées p ou n (38, 40).

4. Procédé de fabrication d'un transistor à effet de champ programmable électriquement comme nœud de mémoire d'un substrat semi-conducteur (2; 24) d'un premier type de conductivité recouvert d'une couche d'isolation (18, 26) en silicium, selon la revendication 1, par dépôt sur la surface de la couche en silice d'une couche en aluminium (16; 32) d'une épaisseur suffisante pour constituer en tenant compte de l'épaisseur de la couche de silice, un masque assez épais pour permettre une implantation ionique ultérieure, par implantation ionique d'une impureté (36) dudit second type de conductivité, qui accroît la conductibilité, à travers ladite couche de silice sous-jacente de la couche métallique, dont une partie de la couche est alignée sur le bord de ladite couche métallique (32), caractérisé en ce que ladite couche métallique est frittée de sorte à amorcer une réaction à l'état solide entre la couche d'aluminium et la couche de silice selon la formule

$$4Al + 3SiO_2 \rightarrow 2Al_2O_3 + 3Si$$

dont le produit est une matrice en alumine et en silicium comprise dans ladite couche en silice (44) alignée sur la partie des zones dopées, laquelle matrice constitue un nœud de stockage programmable électriquement.

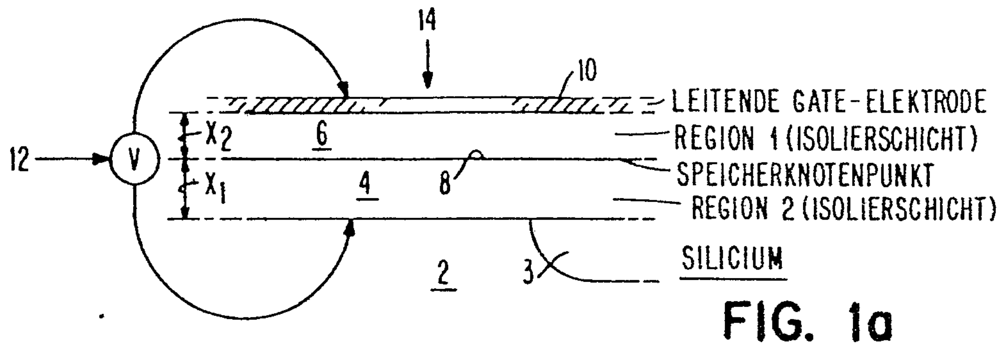


FIG. 1a

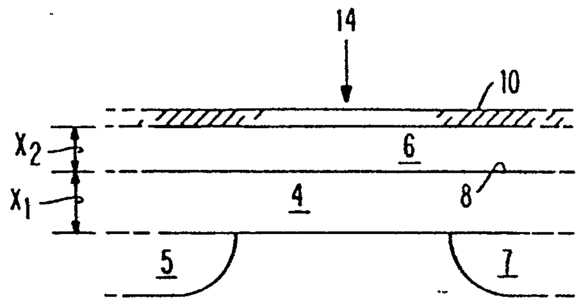


FIG. 1b

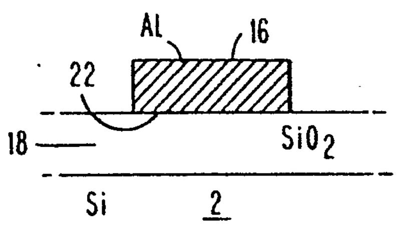


FIG. 2a

VOR DER REAKTION

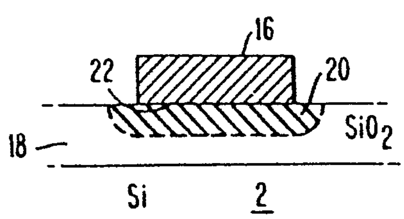


FIG. 2b

NACH DER REAKTION

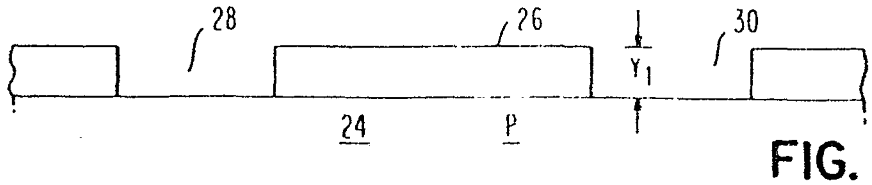


FIG. 3a

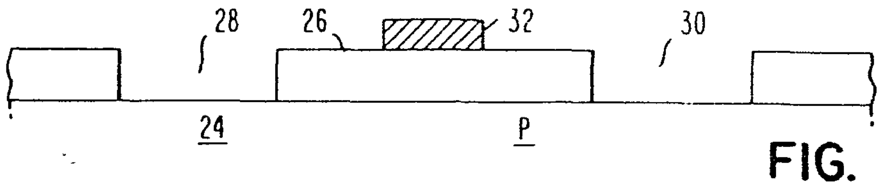


FIG. 3b

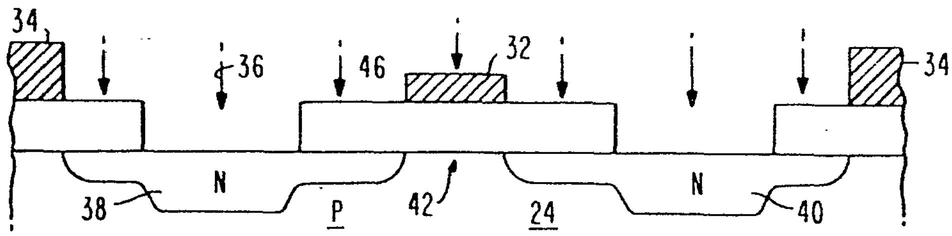


FIG. 3c

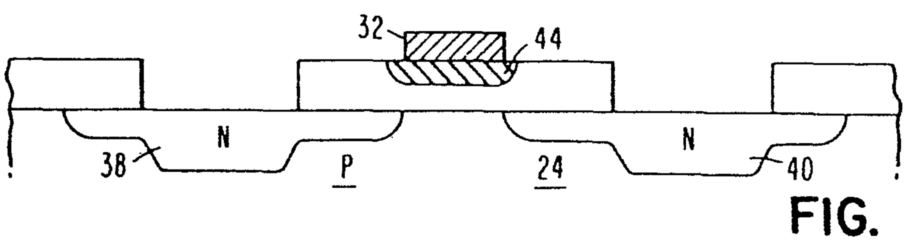


FIG. 3d

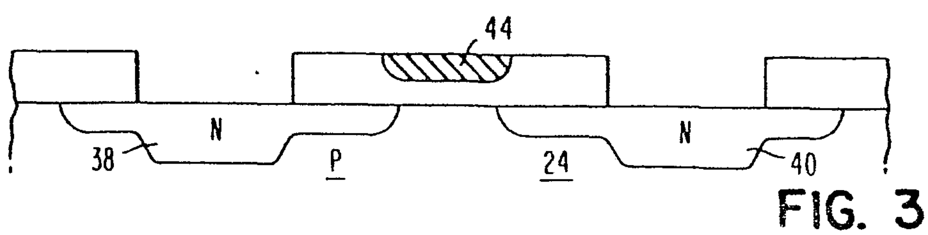


FIG. 3e

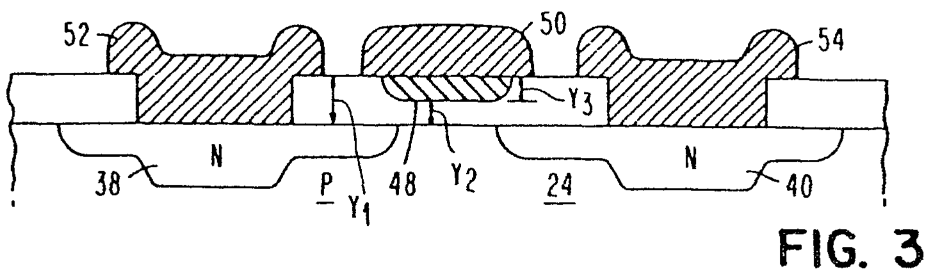


FIG. 3f

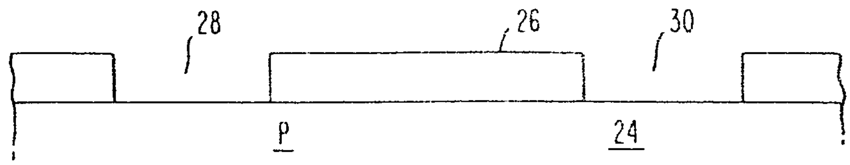


FIG. 4a

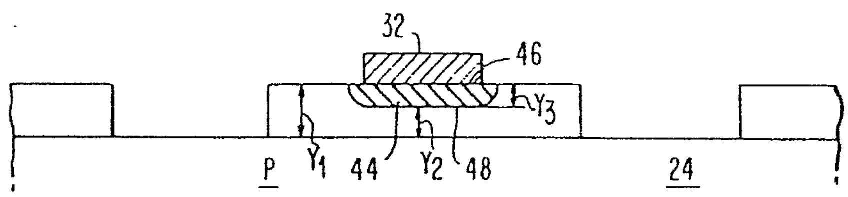


FIG. 4b

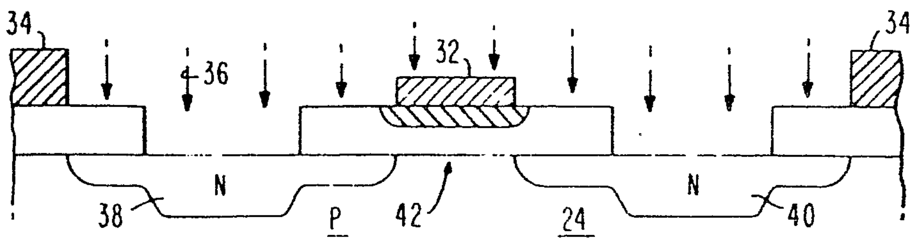


FIG. 4c

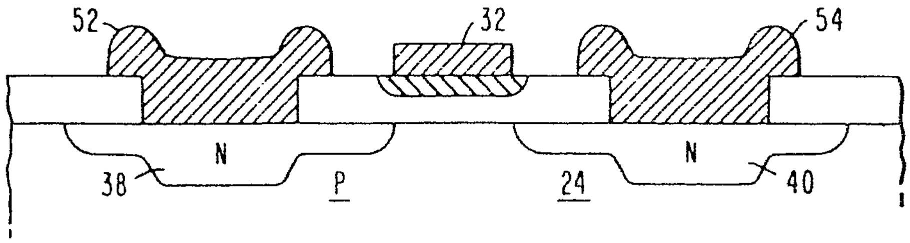


FIG. 4d

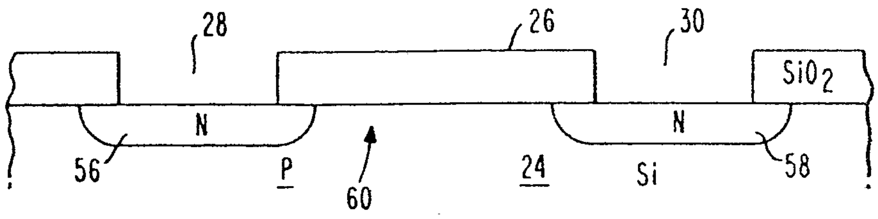


FIG. 5a

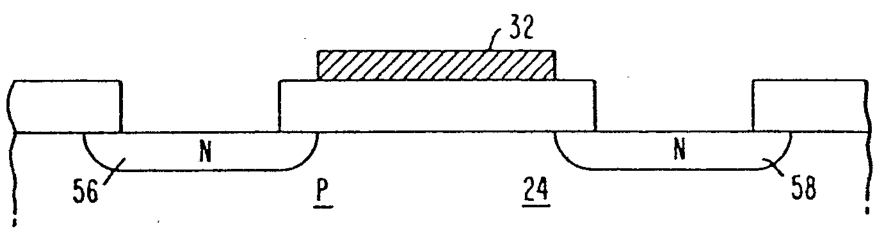


FIG. 5b

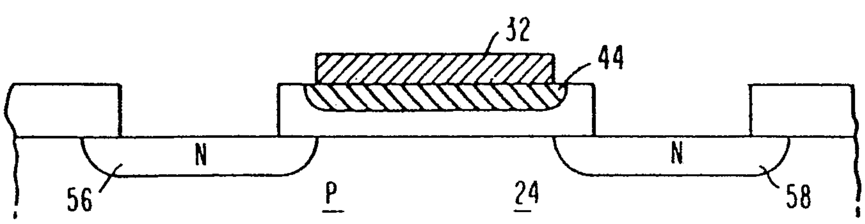


FIG. 5c

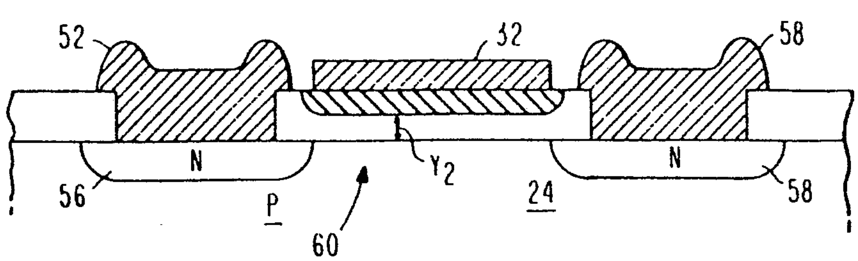


FIG. 5d